Europäisches Patentamt

European Patent Office

Office européen des brevets

(19)

(11) EP 1 118 951 A2

(12) **EUROPEAN PATENT APPLICATION**

(43) Date of publication:
25.07.2001 Bulletin 2001/30

(51) Int Cl.⁷: **G06F 17/50**

(21) Application number: 01300017.9

(22) Date of filing: 03.01.2001

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (72) Inventor: **Zakwan, Shaar**<br>**Stockport SK4 2DG (GB)** |
| (30) Priority: **19.01.2000 GB 0001097**<br>**19.01.2000 GB 0001099** | (74) Representative: **Guyatt, Derek Charles et al**<br>**International Computers Limited**<br>**Intellectual Property Department**<br>**Cavendish Road**<br>**Stevenage, Herts, SG1 2DY (GB)** |
| (71) Applicant: **International Computers Limited**<br>**London, EC2A 1DS (GB)** | |

(54) **Computer-implemented simulation method and apparatus**

(57)     A computer-implemented simulation method comprises modelling a target system as a set of processes and activities that communicate with each other by way of messages and signals. Each message is modelled by a data structure containing sender and receiver queues, and pointers to associated composition and decomposition activities. Similarly, each activity is modelled by a data structure containing a caller queue, and a pointer to an activity process. The simulator uses scheduler queues (event and delta queues) to schedule changes to the state of the model. Each item in each scheduler queue has a type value which indicates whether it relates to a process, activity, message or signal, and items are processed in different ways according to their type. A process-type or activity-type item is processed by calling the process or activity to which the item relates. A message-type item is processed by calling both the sender and receiver processes of the message to which the item relates. A signal-type item is processed by updating the signal state and calling all processes that are sensitive to the signal. A message is scheduled only if at least one sender and receiver exist for the message.

**FIG.11**

EP 1 118 951 A2

## Description

### Background to the Invention

This invention relates to computer-implemented simulation techniques. The invention is particularly, although not exclusively, concerned with simulating the design of computer hardware; it could also be used in simulating other systems, such as complex software systems.

Design specification languages are known, which allow the design of a target system to be specified in terms of a number of functional units that communicate with each other by means of signals. One such language is VHDL [ANSI/IEEE Standard 1076]. The model can then be executed on a VHDL simulator, to simulate the behaviour of the target system.

VHDL+ is a superset of VHDL that extends the capability of the language up to the system design level. In particular, VHDL+ extends the VHDL language by introducing a new primary unit, the interface, which models an interface between two or more design units. Interfaces contain transactions, messages and signals.

One object of the invention is to provide an improved simulation method and apparatus, which can facilitate execution of VHDL+ models. It should be noted, however, that the invention is not restricted to VHDL+, and is also potentially useful in relation to other simulation languages such as Verilog and SystemC.

### Summary of the Invention

According to the invention, a computer-implemented simulation method comprises:

- ■ modelling a target system as a set of processes that communicate with each other by way of messages;
- ■ associating the messages with sender and receiver processes;
- ■ scheduling the messages for processing; and
- ■ processing each scheduled message by calling sender and receiver processes associated with the message.

### Brief description of the drawings

Figure 1 is a block schematic diagram of a simulation system, including a simulation model.

Figure 2 is a block schematic diagram showing possible ways in which the simulation model can be generated.

Figures 3-9 are flow charts showing various processes in the kernel of the simulation model.

Figures 10 and 11 are schematic block diagrams of parts of a simulation model, illustrating composition and decomposition of messages.

### Description of an embodiment of the invention

One simulation system in accordance with the invention will now be described by way of example with reference to the accompanying drawings.

The simulation system uses two forms of simulated time: event time and delta time. Event time is measured in units such as nanoseconds. Delta time is simply an integer that is incremented each time the delta queue is processed.

The system uses two scheduler queues to schedule changes to the state of the model: an event queue for scheduling changes at specified event times, and a delta queue for scheduling changes that are assumed to occur intantaneously.

### Messages and processes

The simulation system to be described is based on a message-process model.

Processes represent specific functional units of the target system (i.e. the particular system that is being simulated). Processes are permanently active during the running of the simulation.

Messages are the basic units of communication between processes. A message is regarded as a resource that is shared between one or more senders and one or more receivers, and is modelled as a data structure (class) with the following attributes.

| | |
|---|---|
| *to* | pointer to interface receiving end |
| *from* | pointer to interface sending end |
| *state* | message state |
| *takes* | time (in nanoseconds) taken to send the message |
| *queued* | message is queued on the event or delta queue |
| *start_t* | start time |
| *compose* | pointer to composition activity |
| *decompose* | pointer to decomposition activity |
| *composing* | composition is active |
| *decomposing* | decomposition is active |
| *snd_cnt* | send count |
| *rcv_cnt* | receive count |
| *data [i]* | message data of ith sender |
| *sender[i]* | pointer to ith sender process |
| *rcv_req_t [i]* | receive request time of ith receiver process |
| *receiver[i]* | pointer to ith receiver process. |

The arrays *data[i]* and *sender[i]* form a sender queue, in which processes waiting to send the message can be queued, with *snd_cnt* pointing to the first free location in this queue. Similarly, the arrays *rcv_req t[i]* and *receiver[i]* form a receiver queue, in which processes waiting to receive the message can be queued, with *rcv_cnt* pointing to the first free location in this queue.

Communication is deemed to commence when a message has at least one sender and at least one receiver, whereupon the message becomes busy for the duration specified by *takes.* Any sender or receiver arriving during this busy period will be queued and will not form part of the current message-process activation sequence.

## Activities

An activity represents a special type of process that terminates. An activity is regarded as a shared resource between contending caller processes. Each activity is modelled as a data structure, with an associated activity process. The data structure has the attributes:

| | |
|---|---|
| *state* | activity state |
| *queued* | the associated activity process is scheduled on the event or delta queue |
| *start_t* | activity start time |
| *call_cnt* | caller count |
| *proc* | pointer to the associated activity process |
| *caller[i]* | pointer to ith caller process. |

The array *caller[i]* forms a caller queue, for queuing caller processes waiting to be served by the activity, with *call_cnt* pointing to the first free location of this queue. An activity must terminate before it can serve the next process in its caller queue.

## Composition and decomposition

Different processes in the simulation model may be specified at different levels of design. For example, one process may expect to receive and send a byte-level message, while another process may expect to receive and send a bit-level message. Composition is the process of constructing a higher level message from a series of lower level messages. Decomposition is the reverse process of expressing a higher level message as a series of lower level messages.

As described above, each message data structure contains pointers (possibly NULL) to composition and decomposition activities for that message. The decomposition activity (if any) is triggered when the message is sent, and the composition activity (if any) is triggered when the message is received.

## Signals

Signals are the basic units of communication between VHDL design unit entities (acting as ports) and VHDL processes of an entity architecture. They are data types, typically used for passing hardware-related low-level information such as bits, bit vectors, registers, buses, etc.

An important feature of the present system is that messages and signals are both handled by the same kernel, using the same scheduling mechanism.

This avoids the need for two separate kernels, which would require considerable synchronisation overheads.

Although VHDL signals are mentioned by way of example, it will be appreciated that the signal concept is generic and can be implemented in any language.

## Scheduler queues

As mentioned above, the system uses two scheduler queues to schedule changes to the state of the model: an event queue for scheduling changes at specified event times, and a delta queue for scheduling changes that are assumed to occur intantaneously.

An event is a data structure, containing the following values:

| | |
|---|---|
| type | the event type |
| *id* | a pointer to a message, process, activity or signal that is to be scheduled. |
| *next_event* | a pointer to the next event in the queue |
| *time* | the event time at which the event is to be activated. |

In the present embodiment, the event type may be one of the following: MESSAGE, PROCESS, ACTIVITY or SIGNAL. Events are handled in different ways according to their type:

- ■ PROCESS or ACTIVITY events are handled by calling the process or activity pointed to by *id.*
- ■ MESSAGE events are handled by calling both the sender and the receiver processes of the message pointed to by *id.*
- ■ SIGNAL events are handled by first updating the signal state and then calling all the processes sensitive to the signal.

A delta is similar to an event, except that it does not contain any *time* value, and has *next_delta* instead of *next_event.* As with events, deltas are handled in different ways according to their type.

Once processed, an event (or delta) is returned to a free event list (or free delta list) for reuse, removing the overhead of constant creation and deletion. A new event or delta is created only when the corresponding free list is empty.

The event queue is based on a time loop having a number of time slots, as described in Patent No. GB2219419. The events are mapped on to the time slots in such a way that events with event times corresponding to different cycles around the loop may be simultaneously present in the same time slot. Events that are mapped into the same time slot are chained together as a linked list, in chronological order. Reference is made to the above mentioned patent for more details. The delta queue is a simple linear list.

### Overview of the system

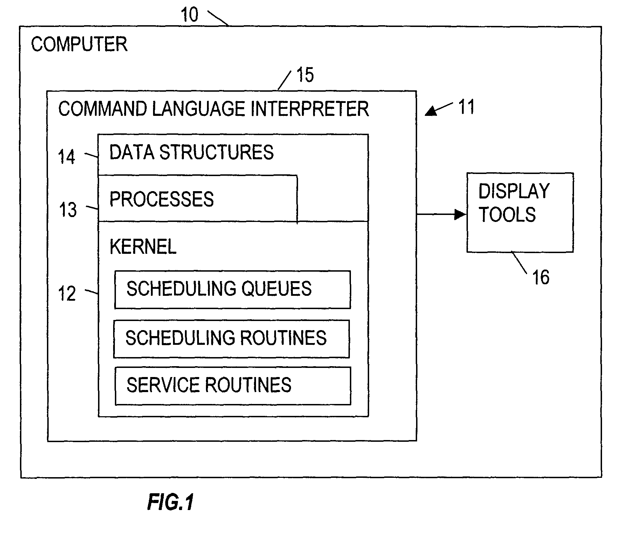

Referring to Figure 1, the simulation system comprises a computer 10, which runs a simulation model 11. The simulation model 11 comprises a Kernel 12, model processes 13, data structures 14, and a command language interpreter 15.

The Kernel 12 is an event-driven process-oriented simulation engine. It comprises scheduling queues (an event queue and a delta queue), a set of scheduling routines, and a set of service routines. These routines are described in detail below.

The processes 13 represent the components of the particular system that is being modelled, and are specific to that system. They are modelled as concurrent state machines, which are re-entered when message passing takes place. In operation, these processes make calls to the Kernel routines, for example to pass messages between processes, and to start and finish activities.

The data structures 14, correspond to the messages, activities, signals and process variables of the model.

The command language interpreter 15 processes user input and output, and manages a number of graphical user interface (GUI) tools 16. The interpreter may, for example, comprise a Tcl/Tk language interpreter. The use of Tcl renders the simulator an open system, capable of integrating and being integrated with other applications.

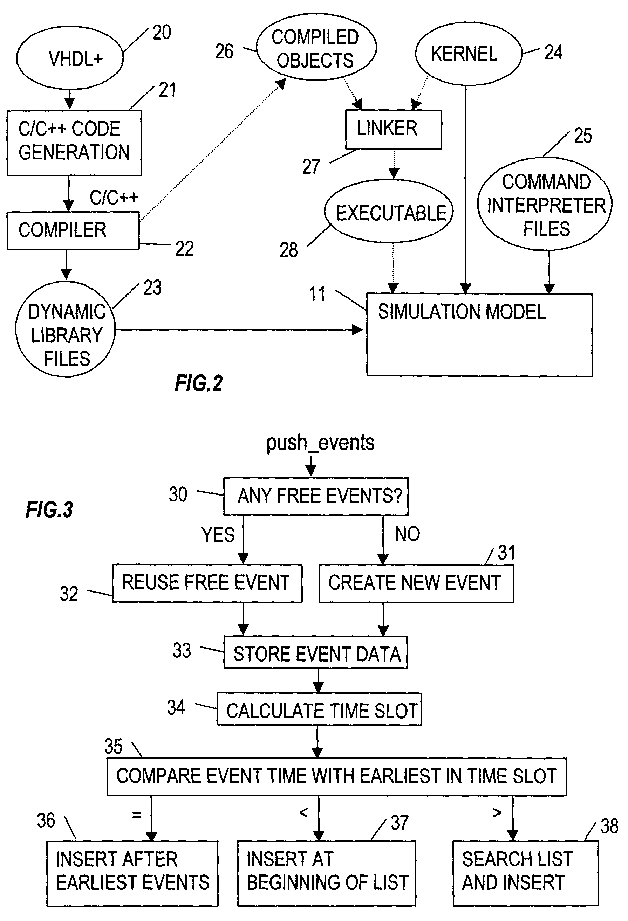

Figure 2 shows the way in which the simulation model 11 can be generated from a VHDL+ source file 20, defining the simulation model in terms of a number of processes, activities messages and signals. First, the VHDL+ source file is used to generate a set of C or C++ (.c) source files, which directly model the semantics of the VHDL+. The generation of the C/C++ files may be performed by hand coding, or by means of an automatic code generation program 21. The C/C++ files are then compiled, by means of a C/C++ compiler 22, to produce a set of shared dynamic (.so) library files 23. The shared library files are then loaded, along with the simulator kernel 24 and library files 25 for the command language interpreter, to form the simulation model.

Alternatively, the compiler 22 may be arranged to generate a set of compiled objects (.o files) 26 which can then be linked with the kernel 24 by means of a linker 27, to form a single executable program 28. This approach is useful for smaller models and for prototyping.

The scheduling and service routines in the Kernel 12 will now be described.

### push_event (type, id, time)

Referring to Figure 3, this routine adds a new event to the event queue to schedule a message, process, activity or signal. The call parameters are:

*type*  the event type (MESSAGE, PROCESS, ACTIVITY or SIGNAL)

*id*  a pointer to the message, process, activity or signal in question

*time*  the event time at which the event is to be scheduled.

(Step 30) The routine first checks whether there are any free events in the free event list.

(Step 31) If there are no free events, a new event data structure is created and allocated to the new event.

(Step 32) Alternatively, if there is a free event, it is removed from the free list and allocated to the new event.

(Step 33) The *type, id,* and *time* values in the event are then set to the corresponding values from the call parameters, while the *next_event* value is set to NULL.

(Step 34) The time slot for the event is then calculated as:

$$time\_slot = (time \ \& \ LOOPBOUND),$$

where LOOPBOUND is the size of the time loop, and "&" represents a bitwise AND.

(Step 35) The routine then compares the event time for the new event with the earliest event time in the list of events for this time slot.

(Step 36) If they are equal, the new event is linked into the list at a position immediately following last of the events with this event time.

(Step 37) If the new event time is earlier than the earliest event time, the new event is added to the beginning of the list.

(Step 38) If the new event time is later than the earliest event time, the list is searched-to find the first event with a later event time, and the new event is inserted in that position. If there is no event with a later event time, the new event is inserted at the end of the list.

### push_delta (type, id)

This routine adds a new delta to the delta queue. The routine first checks whether there are any free deltas in the free delta list. If there is no free delta, a new data structure is created and allocated to the new delta; otherwise, an existing free delta is reused. The new delta is then added to the end of the delta queue. The *type* and *id* values in the delta are set to the corresponding values from the call parameters, and the *next_delta* value is set to NULL.

**pop_events ( )**

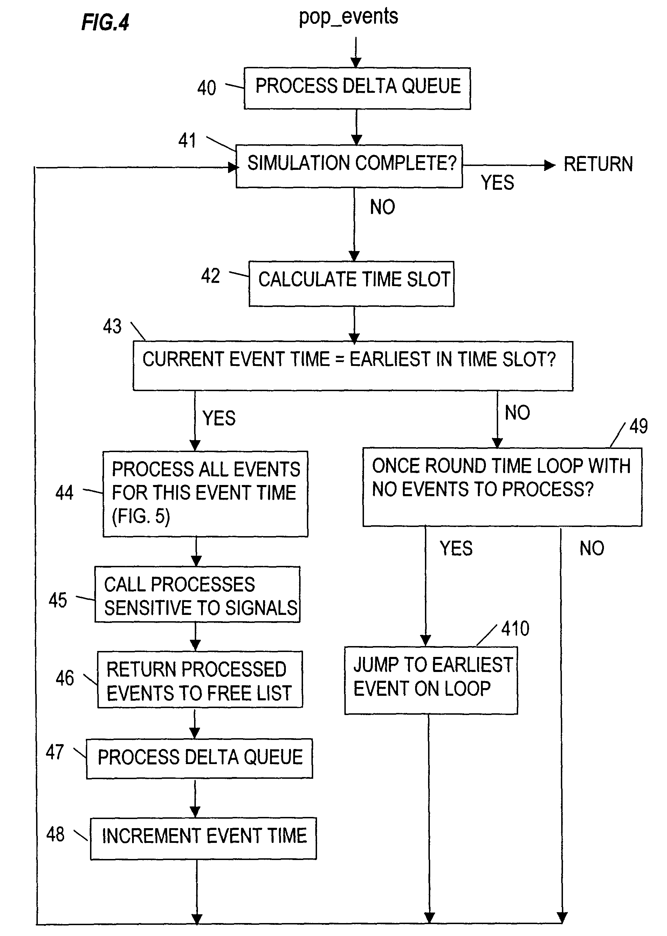

Referring to Figure 4, this routine removes events from the event queue, in the correct sequence and at the correct event times, and process them.

(Step 40) The routine first calls pop_deltas, to process the delta queue.

(Step 41) It then enters a loop (steps 41-49), which is repeated until *event_time* (the current event time) is greater than *simtime* (a predetermined end time for the simulation). When this happens, the process returns a TRUE value, to indicate that the simulation is complete.

(Step 42) The time slot corresponding to the current event time is calculated, as described in step 34.

(Step 43) The current event time is then compared with the event time of the earliest event in the list for this time slot. If they are equal, the process goes to step 44; otherwise, it goes to step 48.

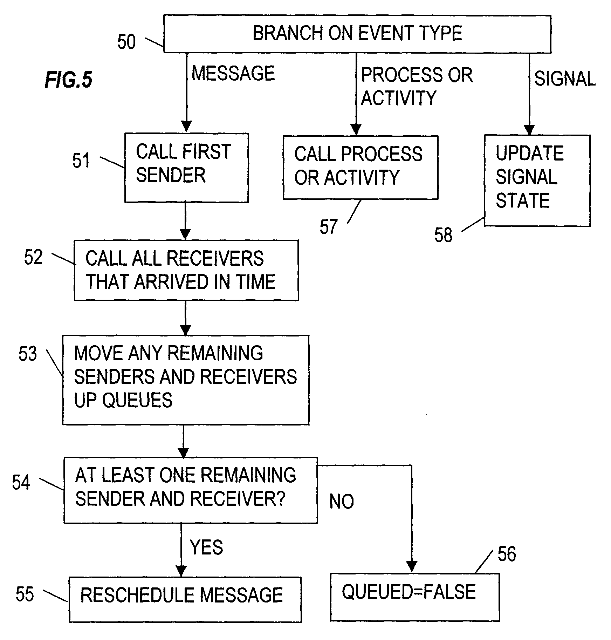

(Step 44) The routine processes all the events in this time slot, with event times equal to *event_time.* The processing of an event depends on its type: MESSAGE events are processed by calling the senders and receivers of the message, while PROCESS and ACTIVITY events are processed by calling the relevant process or activity. SIGNAL events are processed by updating the signal state. The processing of an event is described in more detail below with reference to Figure 5.

(Step 45) If any SIGNAL events were processed in Step 44, a second pass is now performed, to call all processes sensitive to those signals.

(Step 46) The processed events are returned to the free event list.

(Step 47) Pop_deltas is called, to process any deltas that have arrived since last time this was called.

(Step 48) *Event_time* is incremented. The routine then loops back to step 41.

(Step 49) The routine checks whether it has gone once round the timeloop without finding any events to process. This can arise when there are long delays between events.

(Step 410) If so, *event_time* is updated by setting it to the earliest event time encountered in the loop.

Figure 5 shows the processing of an event.

(Step 50) A branch is made according to event type.

(Step 51) If the event type is MESSAGE, the first process on the sender queue for the message is called, and the send count *snd_cnt* is decremented by one.

(Step 52) All processes on the receiver queue that arrived in time are then called. A receiver is considered to have arrived in time if its receive request time *rcv_req_t[i]* is less than or equal to the message start time *start_t*. As each receiver process is called, the message state is set to RECEIVED, and its receive count *rcv_cnt* is decremented by one.

(Step 53) Any remaining senders and receivers are then moved up their respective sender and receiver queues.

(Step 54) A check is then made to determine whether there is at least one remaining sender and receiver in the sender and receiver queues (i.e. *rcv_cnt* and *snd_cnt* are both greater than zero).

(Step 55) If there is at least one remaining sender and receiver, the message is rescheduled to allow these to be processed:

■ set *start_t* = *event_time*
■ set the message state to ACTIVE
■ call push_event, to reschedule the message on the event queue, with *time* = *takes* + *event_time.*

(Step 56) If on the other hand either the sender queue or the receiver queue is empty, *queued* is set to FALSE.

(Step 57) If the event type is PROCESS or ACTIVITY, the process or activity is called.

(Step 58) If the event type is SIGNAL, the signal state is updated.

**pop_deltas ( )**

This routine first checks whether there are any deltas on the delta queue. If there are, it increments the value of *delta_time*, and then processes all the deltas on the queue. The processing of a delta is similar to the processing of an event, as described with reference to Figure 5. In particular, MESSAGE deltas are processed by calling the senders and receivers of the message, while PROCESS and ACTIVITY deltas are processed by calling the relevant processes or activities. SIGNAL deltas are processed by updating the state and then, in a second pass, calling sensitive processes.

**send m (m, proc, data)**

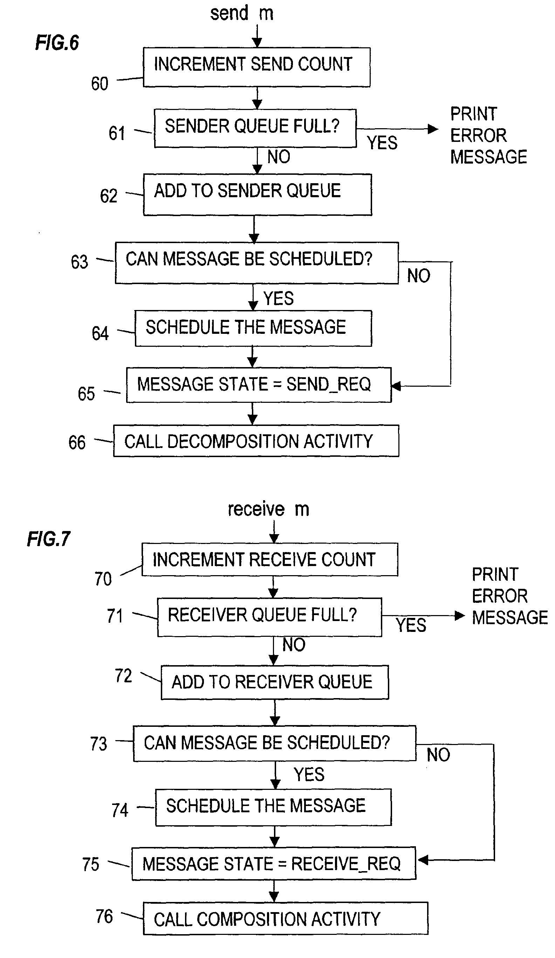

Referring to Figure 6, this routine adds a sender to a message. The call parameters are:

*m*      a pointer to the message data structure
*proc*    a pointer to the sender process
*data*    the message data.

(Step 60) The routine first increments the send count (*snd_cnt*) by one.

(Step 61) It then tests whether the sender queue is full. If so, it prints an error message, and exits. Otherwise, it continues with the following steps.

(Step 62) The routine adds the sender process and the message data to the sender queue.

(Step 63) It then tests whether the message can now be scheduled. This is the case if *decompose* is NULL, *queued* is FALSE, and *rcv_cnt* is greater than zero; that is, there is no decomposition for the message, the message is not currently queued, and there is at least one receiver in the receive queue. If the message cannot be scheduled, the routine goes to Step 65; the message will be scheduled later, e.g. by the receive_m routine.

(Step 64) The message is scheduled, as follows:

-   *queued* = TRUE
-   *state* = ACTIVE
-   *start_t* = *event_time*
-   if *takes* is zero, call push_delta to schedule the message on the delta queue.
-   if *takes* is greater than zero, call push_event to schedule the message on the event queue, with *time* = *takes* + *event_time.*

(Step 65) The message state is set to SEND_REQ.

(Step 66) If a decomposition activity is specified for the message, the decomposition activity is initiated by way of the call_act routine, and *decomposing* is set to TRUE.

**receive_m (m, proc)**

Referring to Figure 7, this routine adds a receiver to a message. The call parameters are:

*m*      a pointer to the message data structure

*proc*    a pointer to the receiver process.

(Step 70) The routine first increments the receive count (*rcv_cnt*) by one.

(Step 71) It then tests whether the receiver queue is full. If so, it prints an error message, and exits. Otherwise, it continues with the following steps.

(Step 72) The routine adds the receiving process and the current event time to the receiver queue.

(Step 73) It then tests whether the message can now be scheduled. This is the case if *compose* is NULL, *queued* is FALSE, and *snd_cnt* is greater than zero; that is, there is no composition for the message, the message is not currently queued, and there is at least one sender in the sender queue. If the message cannot be scheduled, the routine goes to Step 75; the message will be scheduled later, e. g. by the send m routine.

(Step 74) The message is scheduled, as in Step 64.

(Step 75) The message state is set to RECEIVE_REQ.

(Step 76) If any composition activity is specified for the message, the composition activity is initiated by means of the call_act routine, and *composing* is set to TRUE.

**call_act (a, proc)**

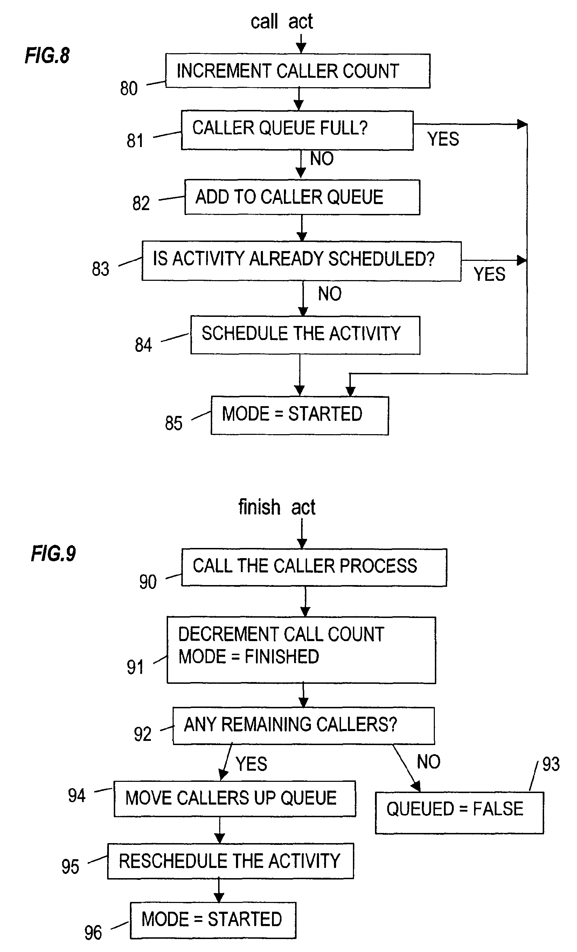

Referring to Figure 8, this routine initiates an activity. The call parameters are:

*a*      a pointer to the activity data structure
*proc*    a pointer to the caller process

(Step 80) The routine first increments the call count *call_cnt* by one.

(Step 81) It then tests whether the caller queue is full. If so, it prints an error message, and jumps to step 85. Otherwise, it continues with the following steps.

(Step 82) The routine sets the activity start time (*start_t*) equal to the current event time, and adds the caller process to the caller queue.

(Step 83) It then tests the activity's *queued* attribute to determine whether the activity is already queued.

(Step 84) If the activity is not already scheduled, it is now scheduled, as follows:

- queued = TRUE
- call push_delta to schedule the activity process on the delta queue.

(Step 85) Finally, the activity mode is set to STARTED.

**finish_act (a)**

Referring to Figure 9, this routine finishes an activity.

(Steps 90-92) The routine calls the first caller process in the caller queue. It then decrements the activity call count (*call_cnt*) by one and sets the activity mode to FINISHED. It then checks whether the call count is greater than zero, i.e. whether there are any remaining callers in the caller queue.

(Step 93) If there are no remaining callers, *queued* is set to FALSE and the routine exits.

(Steps 94-96) If there are any remaining callers, they are moved one place up the caller queue. The routine then calls push_delta, to reschedule the activity process on the delta queue. Finally, the routine sets the activity mode to STARTED.

**finish_c_act (a, m)**

This routine is used to finish a composition or decomposition activity associated with a message. The routine is similar to the finish_act routine described above, except that step 90 is replaced by the following step.
If the *queued* attribute of the message is FALSE, the routine sets it to TRUE, and then calls push_delta, to schedule the message on the delta queue.

**Model Processes**

As mentioned above, the simulation model 11 (Figure 1) includes a number of processes 13 specific to the target system. The processes 13 are modelled as concurrent state machines, which are re-entered when message passing takes place. The processes are concurrent, and their order of execution is random. The processes are called by the Kernel without any parameters, keeping stack size low, which improves performance.
The processes 13 communicate with each other only by way of the send_m and receive m_routines, or by signals, and can launch and terminate activities only through the start_act and finish_act routines.
A process 13 can also directly call push_delta or push_event, to schedule its own recall. For example, if a process requires to wait for a specified time, it calls push_event to schedule a PROCESS event, with a pointer to itself as the *id* parameter. Alternatively, it can call push_delta, to schedule an immediate recall.

**Example of Decomposition**

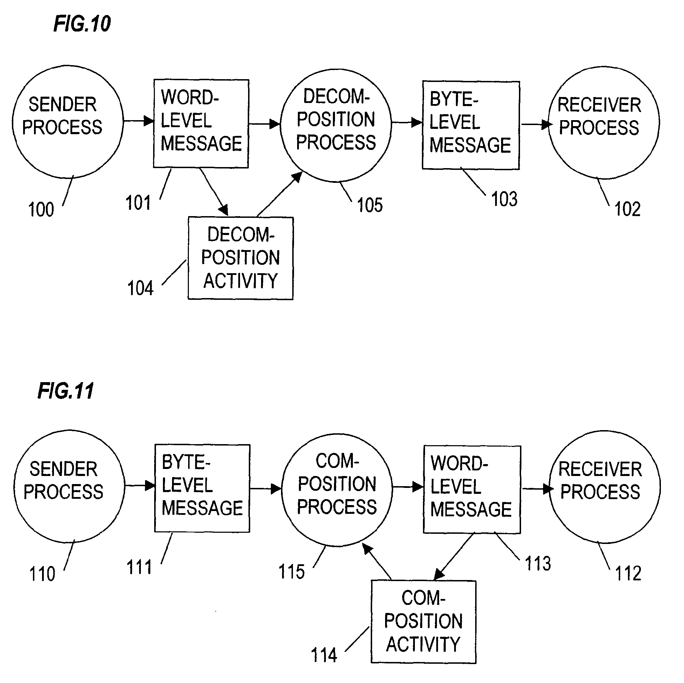

Figure 10 shows an example of part of a simulation model, to illustrate message decomposition. The model comprises a sender process 100, which sends a word-level message 101, and a receiver process 102, which receives a byte-level message 103. The word-level message 101 has a decomposition activity 104 associated with it, which in turn has an associated decomposition process 105.
The sender process 100 calls send_m, to send the word-level message 101, and then suspends. Send_m adds the sender process to the sender queue of message 101, and then calls call_act to initiate the decomposition activity 104. Call_act then calls the decomposition process 105.
Similarly, the receiver process 102 calls receive_m, to receive the byte-level message 103. Receive_m adds the receiver process to the receiver queue of the message 103.
The decomposition process 105 in this example is implemented as a state machine with four states (State 0 - State 3); the operation of the process depends on its state when called.
State 0: The decomposition process extracts the next data byte from the word-level message 101, and calls send_m to send the byte-level message 103 with this data byte. It then advances to State 1 and suspends. Send_m adds the decomposition process as a sender to the sender queue of the byte-level message 103. Assuming that the message 103 now has both a sender and a receiver, this message can now be scheduled.
State 1: The decomposition process calls push_event, to reschedule itself after delay of one byte time. The process then advances to State 2, and suspends.
State 2: The decomposition process checks whether it has completed the decomposition (i.e. has processed all 4 bytes from the word). If the decomposition is not complete, it calls push_delta to reschedule itself immediately. The process then returns to State 0, and suspends. When recalled, the process will send the next data byte.
If decomposition is complete, the decomposition process calls receive_m, to receive the word-level message 101. It then advances to State 3 and suspends. Receive_m will add the decomposition process 105 as a receiver to the receiver queue of the word-level message 101. Assuming that the message 101 now has both a sender and a receiver, this message can now be scheduled.
State 3: The decomposition process resets the *decomposing* attribute of the word-level message to FALSE, and calls finish_c_act, to finish the decomposition activity. The decomposition process then returns to State 0 and suspends.

**Example of Composition**

Figure 11 shows an example of part of a simulation model, to illustrate message composition. The model comprises a sender process 110, which sends a byte-level message 111, and a receiver process 112, which receives a word-level message 113. The byte-level message 111 has a composition activity 104 associated with it, which in turn has an associated composition process 115.

The sender process 110 calls send_m, to send the byte-level message 111. Send_m adds the sender process to the sender queue of message 111.

Similarly, the receiver process 112 calls receive_m, to receive the word-level message 113. Receive_m adds the receiver process to the receiver queue of the message 113, and then calls call act, to initiate the composition activity 114. Call_act then calls the composition process 115.

The composition process 115 in this example is implemented as a state machine with four states (State 0 - State 3).

State 0: The composition process calls receive_m to receive the byte-level message 111. The received data byte is accumulated in a variable *rnum*. The process then advances to State 1 and suspends. Receive_m adds the composition process as a receiver to the receiver queue of the byte-level message 111. Assuming that the message 111 now has both a sender and a receiver, this message can now be scheduled.

State 1: The composition process calls push_event, to reschedule itself after a delay of one byte time. The process then advances to State 2, and suspends.

State 2: The composition process checks whether it has completed the composition (i.e. has received all 4 data bytes of the word). If the composition is not complete, it calls push_delta to reschedule itself immediately. It the returns to State 0, and suspends. When recalled, the process will receive the next data byte.

If composition is complete, the composition process calls send_m, to send the word-level message 113 with the accumulated data *rnum*. It then advances to State 3 and suspends. Send m adds the composition process 115 as a sender to the sender queue of the word-level message 113. Assuming that the message 113 now has both a sender and a receiver, this message can now be scheduled.

State 3: The composition process resets the *composing* attribute of the word-level message to FALSE, and calls finish_c_act, to finish the composition activity. The composition process then returns to State 0 and suspends.

**Some possible modifications**

It will be appreciated that many modifications may be made to the system described above without departing from the scope of the present invention. For example, the invention may be applied to simulation environments other than VHDL+, and may be implemented using various different programming languages.

Although only four event and delta types (MESSAGE, PROCESS, ACTIVITY and SIGNAL) are described in the above example, other types could also be specified. For example, the VHDL+ TRANSACTION type could be introduced to model multi-directional message passing between two or more ends of the interface.

**Claims**

1.  A computer-implemented simulation method comprising:

    - modelling a target system as a set of processes that communicate with each other by way of messages;
    - associating the messages with sender and receiver processes;
    - scheduling the messages for processing; and
    - processing each scheduled message by calling sender and receiver processes associated with the message.

2.  A method according to Claim 1 wherein the step of associating the messages with sender and receiver processes comprises:

    - providing a message data structure for each of the messages;
    - when a process requires to send a message, adding that process to the relevant message data structure as a sender;
    - when a process requires to receive a message, adding that process to the relevant message data structure as a receiver;

3.  A method according to Claim 2, further including:

    - when a process is added as a sender for a message, scheduling the message for processing only if at least one receiver for the message already exists in the message data structure; and
    - when a process is added as a receiver for a message, scheduling the message for processing only if at least one sender for the message already exists in the message data structure.

4.  A method according to Claim 2 or 3 wherein each message data structure includes a sender queue and a receiver queue, for queuing a number of sender and receiver processes.

**5.** A method according to any one of Claims 2 to 4 further including checking the message data structure when a message has been processed, to determine whether there is at least one remaining sender and receiver for the message and, if so, rescheduling the message.

**6.** A method according to any one of Claims 2 to 5 wherein each message data structure holds pointers to a composition activity, for composing a higher-level message from a lower-level message, and to a decomposition activity, for decomposing a higher-level message into a lower-level message.

**7.** A method according to Claim 6 wherein the composition activity performs multiple receives of the lower-level message followed by a single send of the higher-level message.

**8.** A method according to Claim 6 or 7 wherein the decomposition activity performs multiple sends of the lower-level message followed by a single receive of the higher-level message.

**9.** A method according to any one of Claims 6 to 8 wherein:

- the decomposition activity for a message is activated when a process is added as a sender for that message; and
- the composition activity for a message is activated when a process is added as a receiver for that message.

**10.** A method according to any preceding claim wherein the step of scheduling the messages for processing comprises providing at least one scheduler queue, which is used for scheduling both messages and processes.

**11.** A method according to Claim 10 including the steps:

- scheduling the processes and messages by placing process-type items and message-type items on the scheduler queue;
- processing each process-type item on the scheduler queue by calling the process to which the item relates; and
- processing each message-type item on the scheduler queue by calling both the sender and receiver processes of the message to which the item relates.

**12.** A method according to Claim 10 or 11 wherein processes also communicate with each other by way of signals, and wherein said scheduler queue is used for scheduling the signals as well as the messages and processes.

**13.** A method according to Claim 12 including the steps:

- scheduling the signals by placing signal-type items on the scheduler queue; and
- processing each signal-type item on the scheduler queue by updating the signal state and calling all processes that are sensitive to the signal.

**14.** A method according to any one of Claims 10 to 13 wherein there are two scheduler queues: an event queue for scheduling changes that are to take place at specified times, and a delta queue for scheduling changes that are to take place instantaneously.

**15.** A method according to any preceding claim, including:

- providing an activity data structure for each of a plurality of activities, each activity data structure including a pointer to an associated activity process and a caller queue for queuing a number of caller processes;
- when a caller process requires to call an activity, adding the caller process to the caller queue of the related activity data structure, and scheduling the activity for processing;
- processing each scheduled activity by calling its associated activity process.

**16.** A method according to Claim 15 wherein the activity is scheduled only if it is not already scheduled for processing.

**17.** A method according to Claim 15 or 16 wherein, when an activity process finishes its processing:

- the corresponding caller process is removed from the caller queue; and
- if there are still any remaining caller processes in the caller queue, the activity is rescheduled.

**18.** A computer-implemented simulation method comprising the steps:

- modelling a target system as a set of processes that communicate with each other by way of messages;
- associating the messages with sender and receiver processes;
- providing at least one scheduler queue, holding a series of items, each item having a type value which indicates the item type;
- scheduling the processes and messages by placing process-type items and message-type items on the scheduler queue;

- processing each process-type item on the scheduler queue by calling the process to which the item relates; and
- processing each message-type item on the scheduler queue by calling both the sender and receiver processes of the message to which the item relates.

19. A data carrier, carrying a computer-readable program for performing a computer-implemented simulation method comprising:

- modelling a target system as a set of processes that communicate with each other by way of messages;
- associating the messages with sender and receiver processes;
- scheduling the messages for processing; and
- processing each scheduled message by calling sender and receiver processes associated with the message.

FIG.1

VHDL+  /20

↓

C/C++ CODE GENERATION  /21

↓ C/C++

COMPILER  22

↓

DYNAMIC LIBRARY FILES  /23

26  COMPILED OBJECTS

KERNEL  24

LINKER  27

EXECUTABLE  28

COMMAND INTERPRETER FILES  /25

11  SIMULATION MODEL

*FIG.2*

---

*FIG.3*

push_events

↓

30 — ANY FREE EVENTS?

YES ↓          NO ↓

32 — REUSE FREE EVENT          CREATE NEW EVENT  /31

↓                                    ↓

33 — STORE EVENT DATA

↓

34 — CALCULATE TIME SLOT

↓

35 — COMPARE EVENT TIME WITH EARLIEST IN TIME SLOT

=  ↓                <  ↓                >  ↓

36 — INSERT AFTER EARLIEST EVENTS          INSERT AT BEGINNING OF LIST  /37          SEARCH LIST AND INSERT  /38

**FIG.4**

pop_events

40 — PROCESS DELTA QUEUE

41 — SIMULATION COMPLETE? —— YES —→ RETURN

NO

42 — CALCULATE TIME SLOT

43 — CURRENT EVENT TIME = EARLIEST IN TIME SLOT?

YES

44 — PROCESS ALL EVENTS FOR THIS EVENT TIME (FIG. 5)

45 — CALL PROCESSES SENSITIVE TO SIGNALS

46 — RETURN PROCESSED EVENTS TO FREE LIST

47 — PROCESS DELTA QUEUE

48 — INCREMENT EVENT TIME

NO

49 — ONCE ROUND TIME LOOP WITH NO EVENTS TO PROCESS?

YES

410 — JUMP TO EARLIEST EVENT ON LOOP

NO

**FIG.5**

```
                    ┌─────────────────────────────────────┐
        50          │      BRANCH ON EVENT TYPE            │
                    └─────────────────────────────────────┘
                         │            │              │
                    MESSAGE    PROCESS OR         SIGNAL
                               ACTIVITY
                         │            │              │
                         ▼            ▼              ▼
                    ┌──────────┐ ┌──────────────┐ ┌──────────┐
        51          │CALL FIRST│ │CALL PROCESS  │ │UPDATE    │
                    │SENDER    │ │OR ACTIVITY   │ │SIGNAL    │
                    └──────────┘ └──────────────┘ │STATE     │
                         │           57            └──────────┘
                         │                          58
                         ▼
                    ┌────────────────────┐
        52          │CALL ALL RECEIVERS  │
                    │THAT ARRIVED IN TIME │
                    └────────────────────┘
                         │
                         ▼
                    ┌────────────────────┐
        53          │MOVE ANY REMAINING  │
                    │SENDERS AND RECEIVERS│
                    │UP QUEUES           │
                    └────────────────────┘
                         │
                         ▼
                    ┌────────────────────┐
        54          │AT LEAST ONE REMAINING│──── NO ────┐
                    │SENDER AND RECEIVER? │            │
                    └────────────────────┘            │
                         │                            │
                        YES                           ▼
                         ▼                       ┌──────────────┐
                    ┌────────────────────┐       │QUEUED=FALSE  │  56
        55          │RESCHEDULE MESSAGE  │       └──────────────┘
                    └────────────────────┘
```

**FIG.6**

send m

60 — INCREMENT SEND COUNT

61 — SENDER QUEUE FULL? — YES → PRINT ERROR MESSAGE

NO

62 — ADD TO SENDER QUEUE

63 — CAN MESSAGE BE SCHEDULED? — NO

YES

64 — SCHEDULE THE MESSAGE

65 — MESSAGE STATE = SEND_REQ

66 — CALL DECOMPOSITION ACTIVITY

**FIG.7**

receive m

70 — INCREMENT RECEIVE COUNT

71 — RECEIVER QUEUE FULL? — YES → PRINT ERROR MESSAGE

NO

72 — ADD TO RECEIVER QUEUE

73 — CAN MESSAGE BE SCHEDULED? — NO

YES

74 — SCHEDULE THE MESSAGE

75 — MESSAGE STATE = RECEIVE_REQ

76 — CALL COMPOSITION ACTIVITY

*FIG.8*

call act

INCREMENT CALLER COUNT
80

CALLER QUEUE FULL?
81
YES

NO

ADD TO CALLER QUEUE
82

IS ACTIVITY ALREADY SCHEDULED?
83
YES

NO

SCHEDULE THE ACTIVITY
84

MODE = STARTED
85

*FIG.9*

finish act

CALL THE CALLER PROCESS
90

DECREMENT CALL COUNT
MODE = FINISHED
91

ANY REMAINING CALLERS?
92

YES

NO

93

MOVE CALLERS UP QUEUE
94

QUEUED = FALSE

RESCHEDULE THE ACTIVITY
95

MODE = STARTED
96

**FIG.10**

SENDER PROCESS
100

→

WORD-LEVEL MESSAGE
101

→

DECOM-POSITION PROCESS
105

→

BYTE-LEVEL MESSAGE
103

→

RECEIVER PROCESS
102

DECOM-POSITION ACTIVITY
104

**FIG.11**

SENDER PROCESS
110

→

BYTE-LEVEL MESSAGE
111

→

COM-POSITION PROCESS
115

→

WORD-LEVEL MESSAGE
113

→

RECEIVER PROCESS
112

COM-POSITION ACTIVITY
114